# EUROPEAN PATENT SPECIFICATION

(11) **EP 0 465 160 B1**
(45) Date of publication and mention of the grant of the patent: **04.09.1996**
(21) Application number: 91305882.2
(22) Date of filing: 28.06.1991
(51) Int. Cl.: G11C 8/00, G11C 7/00

(54) **Multiport memory**
Multiportspeicher
Mémoire multiporte

(30) Priority: 29.06.1990 JP 173327/90
(43) Date of publication of application: 08.01.1992
(73) Proprietor: SONY CORPORATION, Tokyo 141 (JP)
(72) Inventor: Iwase, Seiichiro, c/o Patents Division, Shinagawa-ku, Tokyo 141 (JP)
(74) Representative: Cotter, Ivan John

(56) References cited:
- EP-A- 0 171 518

## Description

This invention relates to a multiport memory suitable for image processing applications.

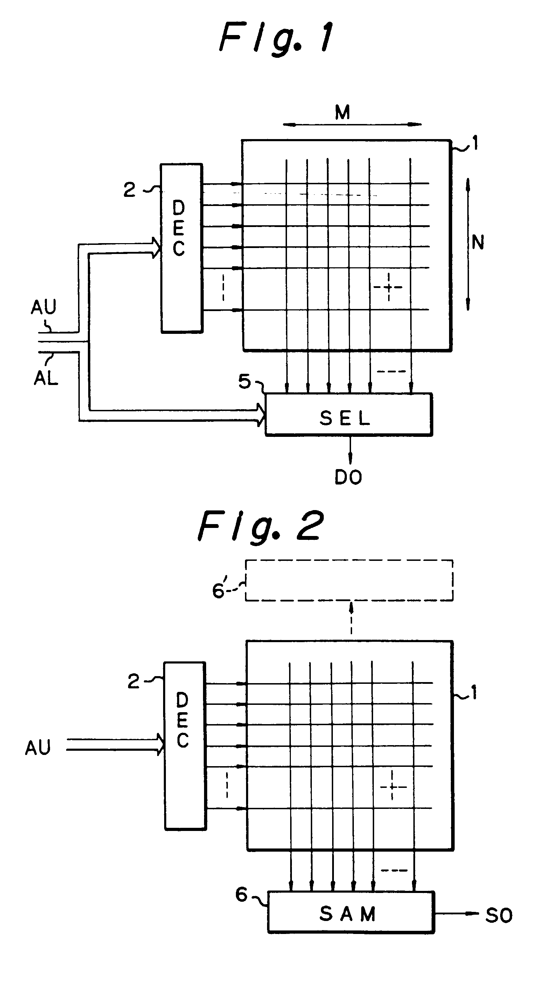

A conventional semiconductor memory is illustrated in Figure 1. A row of a memory 1 of (M columns x N rows) elements is selected by the output of a decoder 2 corresponding to the upper bits AU of an address. Connecting lines of columns of the memory 1 are connected to a selector 5. Selective control of the selector 5 by lower bits AL of the address enables read data D0 to be provided from the selector 5. The upper bits AU are log₂ N bits, and the lower bits AL are log₂ M bits. For reasons of ease of illustration. Figure 1 shows only the situation for read-out from the memory 1.

Recently, a dual port memory or a video memory suited for the storage of video signals in a raster scanning data sequence has been proposed. As shown in Figure 2, this type of memory has a port for serial output data SO. For this type of output only a row address is given to the decoder 2, whereby read-out data from one row is serially output from a shift register 6 called a serial access memory or SAM, the serial output data SO being taken out subsequently. Usually, row data is loaded into the shift register 6 in a parallel fashion, and the output can be made at independent speed from the serial port.

The port for the output data D0 of Figure 1 is called a random access port, and the port for the output data S0 of Figure 2 is called a serial port. Such a memory where both of these ports are provided in the same memory is called a "dual port memory" or "video memory".

The dual port memory is useful in an image processing circuit. There is a case where plural serial ports are needed. Conventionally, in Figure 2, it is possible to have two serial ports by providing another shift register 6' at a position indicated by the broken line. However, the provision of serial ports equal to or larger than 3 is difficult.

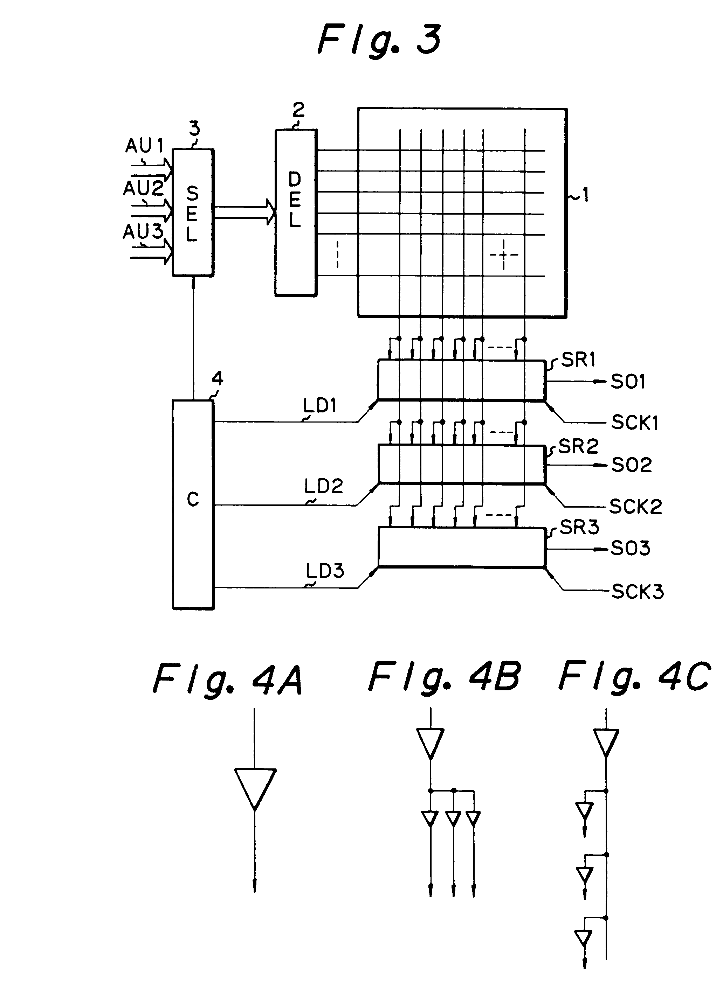

Figure 3 illustrates the provision of plural serial ports. It is considered that the shift registers SR1, SR2, and SR3 illustrated in Figure 3 are connected in parallel to the column connecting lines of the memory 1 and the ports of serial outputs S01, S02, and S03 are taken out from the respective shift registers. Shift clocks SCK1, SCK2, and SCK3 are supplied to the shift registers SR1, SR2, and SR3, and parallel load signals LD1, LD2, and LD3 are given from a control circuit 4. In addition, upper bits AU1, AU2, and AU3 of addresses corresponding to the respective ports are given to the selector 3, and one of these upper bits is selected by a control signal from the control circuit 4.

For instance, in response to the selection of the upper bit AU1 by the selector 3, the load signal LD1 is fed to the shift register SR1. As a result, row data accessed by the AU1 is loaded in parallel to the shift register SR1. The data of the shift register SR1 is output as the serial data SO1 at the shift clock SCK1. In the structure shown in Figure 3, the column connecting lines need to drive the three shift registers SR1, SR2, and SR3. Consequently, the load on these column connecting lines becomes heavy compared to driving only one shift register. A powerful driver (buffer circuit) has a large area as shown in Figure 4A. Alternatively, as shown in Figure 4B or Figure 4C, it is possible to employ one middle-class driver and three drivers to enable drive capability to be increased. However, in any one of the structures shown in Figure 4, the circuit size is so large that their incorporation in the memory 1 is impracticable. As a result, the realization of a multiport memory having many serial ports has not been achieved.

An object of the invention is, therefore, to provide a multiport memory having a plural number (P) of serial ports.

European Patent Application Publication No. EP-A-0 171 518 discloses a multiport memory according to the pre-characterising part of claim 1 hereof.

According to the invention, there is provided a multiport memory comprising:
a first register having inputs connected to respective connecting lines of either the rows or columns of a semiconductor memory;
a second register having inputs connected to respective outputs of said first register and permitting a serial shift;
a port provided at a serial terminal of said second register; and control means for controlling addressing of the semiconductor memory and for controlling operation of the first and second registers;
characterised in that:
the multiport memory comprises a plural number P of said first registers, the inputs of a first one of the P first registers being connected to the respective connecting lines of either the rows or columns of the semiconductor memory and the inputs of the or each subsequent one of the P first registers being connected to respective outputs of the preceding one of the P first registers;
the multiport memory also comprises a plural number P of said second registers, the inputs of each of the P second registers being connected to the respective outputs of a respective one of the P first registers;
each of the P second registers permits a serial shift, and a respective said port is provided at a serial terminal of each of the P second registers; and
the control means is operative to cause an address to be supplied to either the columns or rows of the semiconductor memory, to cause a parallel load into the first of the P first registers and to cause a shift operation to sequentially cause a parallel load into the rest of the P first registers or to cause a load into the second registers. Embodiments of the invention will be described hereinafter, by way of example only, with respect to the accompanying drawings in which:

Figure 1 is a block diagram of a conventional semiconductor memory;
Figure 2 is a block diagram of a dual port memory;
Figure 3 is a conceptual block diagram of a multiport memory;
Figure 4 is a block diagram used for explaining a problem inherent in the structure of Figure 3;
Figure 5 is a block diagram of one embodiment of this invention;
Figure 6 is a timing chart of the embodiment of Figure 5; and
Figure 7 is a block diagram of another embodiment of the invention.

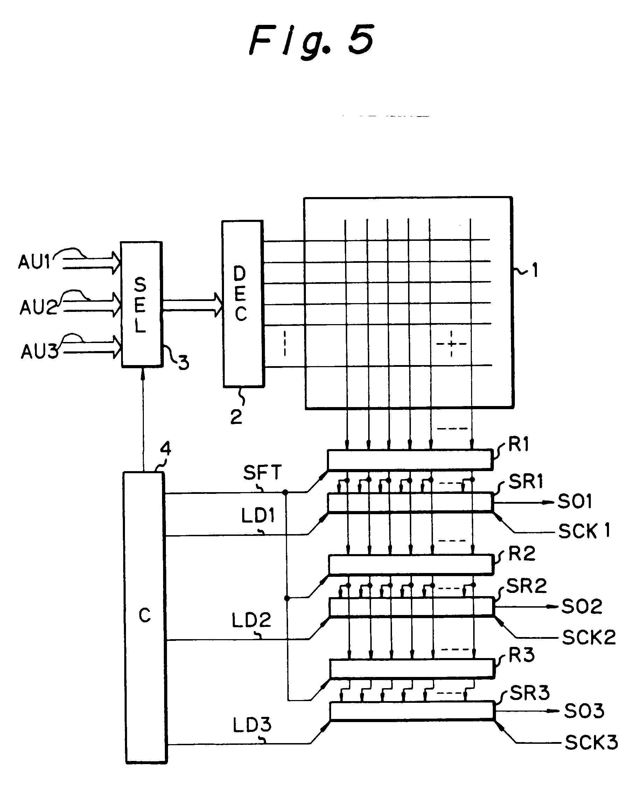

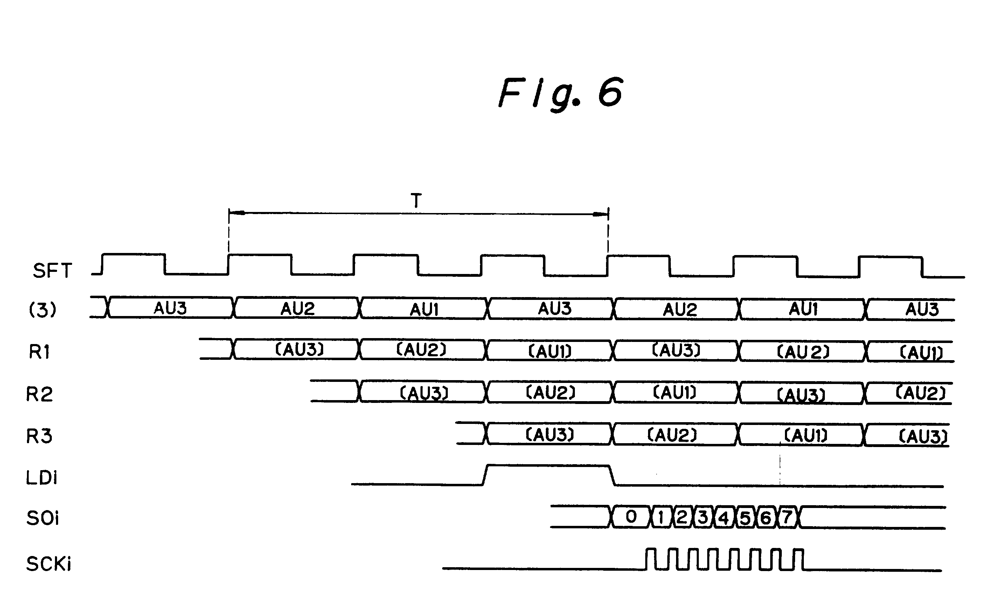

One embodiment of this invention will be described with reference to Figures 5 and 6 wherein Figure 5 is a schematic block diagram of the structure of this embodiment, and Figure 6 is a timing chart therefor. In Figure 5, a semiconductor memory 1 has elements taking the form of a matrix of (N rows x M columns). A row of the memory 1 is selected by the output of a decoder 2. For reasons of simplicity of illustration and explanation, the embodiment is limited to the structure and operation for read-out only. Also, for the same reasons, the representation of a random access port in the drawing is omitted.

The upper bits of an address selected at a selector 3 are supplied to the decoder 2. For example, three upper bits AU1, AU2, and AU3 are given to the selector 3. The bit number of each of the upper bits is log₂ N bits. The selector 3 is controlled by a control signal from a control circuit 4.

M connecting lines of the memory 1 from which read data of one row is generated are connected to input terminals of a register R1. Input terminals of a register R2 are connected to M output terminals of the register R1. Input terminals of a register R3 are connected to M output terminals of the register R2. A shift clock SFT is given to these registers R1, R2 and R2 for vertical shift in Figure 5. Parallel input terminals of shift registers SR1, SR2, and SR3 are connected to the output terminals of the registers R1, R2, R3, respectively.

Parallel load signals LD1, LD2, and LD3 are supplied to the shift registers SR1, SR2, and SR3, respectively from the control circuit 4. The outputs of the registers are loaded into the respective shift registers at the timing of the parallel load signals. The shift clocks SCK1, SCK2, and SCK3 are supplied to the shift registers SR1, SR2, and SR3, respectively, and the contents of the shift registers are produced as serial outputs S01, S02, and S03 by the shift clocks. The shift clocks SCK1, SCK2, and SCK3 have a higher operating frequency than the access operation for the memory 1. In this example, assuming that the access time of the memory 1 is T/3, the clock period is selected at (T/3). "T" is the operation cycle of the multiport memory. This clock is used not only as the clock for the control circuit 4 but also as the shift clocks for the registers R1, R2, and R3.

As shown in the timing chart of Figure 6, in the above-described embodiment, the upper bits of an address are selected by a control signal from the control circuit 4 at the selector 3 in descending order (ie, in the order of AU3, AU2, and AU1). Upon this happening, the shift clock SET is generated from the control circuit 4 so that the registers R1, R2, and R3 are shifted sequentially. The registers R1, R2, and R3 operate similarly to the shift registers. At the timing of completion of three row accesses, the contents of the registers R1, R2, and R3 are loaded into the shift registers SR1, SR2, and SR3 in a parallel manner. In Figure 6 [AU1] [AU2] [AU3] represent data which had been written into the address AU1, AU2, and AU3. The contents of the shift registers SR1, SR2, and SR3 are output as the serial outputs S01, S02, and S03. In Figure 6, the shift clocks are given to the shift registers SR1, SR2, and SR3, and, for instance, 8 bits of [AU1] [AU2] [AU3] are output.

The control of the control circuit 4 generates control signals repeatedly in a predetermined sequence. In that case, the parallel load signals LD1, LD2, and LD3 are not output selectively to the ports for which access is not needed.

In this embodiment, there is restriction that only one load for each port is permitted for P cycles where P is the number of the serial ports. However, if P is not a large number, as is generally the case, and if access to the serial ports is done in succession to some degree, such a restriction does not matter. Since the degree of continuity of access is high in image processing, the influence of the restriction on access is small. For example, when ten serial ports are provided for a memory 1 of 10 kilobits of (M = 100 bits, N = 100 bits), 100-bit data is output serially from each port, and free access to each port is substantially possible even with the use of 10 ports.

A layout where the registers and shift registers are disposed not only on the lower side of the memory 1 in Figure 5 but also on the upper side may be employed.

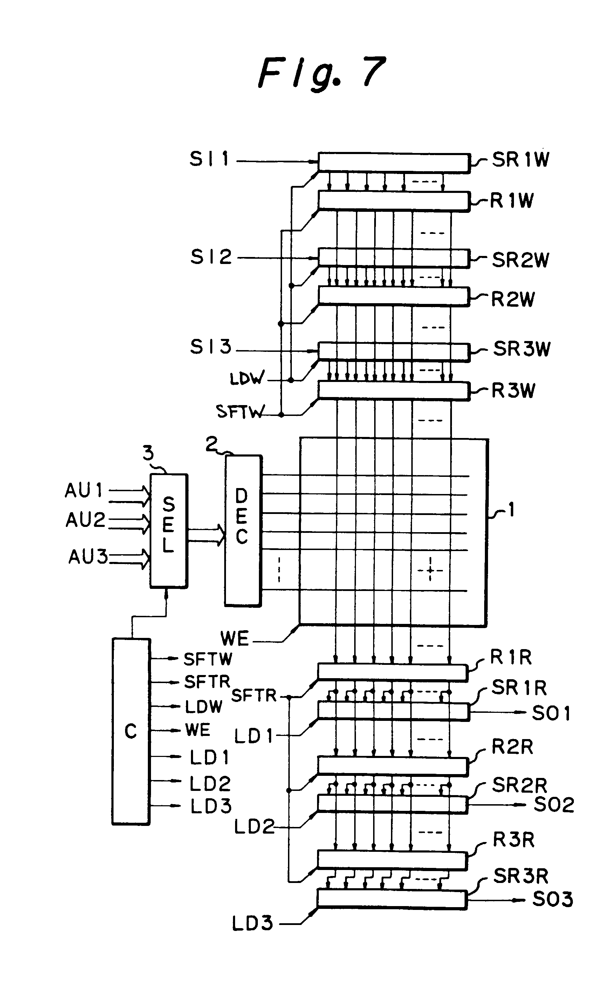

Figure 7 shows another embodiment of the invention. On the lower side of the memory 1, the connecting lines of the memory 1 as same as Figure 5. Registers R1R, R2R, and R3R and shift registers SR1R, SR2R, and SR3R relating to the ports from which the read-out outputs S01, S02, and S03 are taken, are connected to these M connecting lines.

On the upper side of the memory 1, parallel output terminals of a register R3W are connected to the column connecting lines. To parallel input terminals of the register R3W, parallel output terminals of a register R2W are connected. To parallel input terminals of a register R2W, parallel output terminals of a register R1W are connected. To each register, output terminals of the shift registers SR1W, SR2W and SR3W are connected. In this manner, write-in data transfer from the shift registers SR1W, SR2W, and SR3W to the registers R1W, R2W and R3W can be achieved by a parallel load signal LDW.

Serial write-in data SI1, SI2, and SI3 are supplied to the shift registers SR1W, SR2W, and SR3W.

For performing the write-in operation, a control signal WE is supplied from the control circuit 4 to the memory 1. The control circuit 4 generates the shift clocks SFTW, SFTR, and parallel load signals LDW, LD1, LD2, and LD3.

In the embodiment indicated in Figure 7, multiports for write-in and multiports for read-out can be provided.

Here, the number of the ports is not limited to three. Also, in place of selector 3 for selecting upper bits of an address, a structure in which plural upper bits are given through a bus buffer to a common bus can be employed.

The invention provides a multiport memory suited for image processing, since the drive for only one register in the memory 1 is needed, which reduces the loading.

Thus, there have been described embodiments of a multiport memory which comprises:
P parallelly connected registers (M bits wide) of which a first one is connected to either the row or column lines of a semiconductor memory;
P second registers (M bits wide) each connected to the output of a respective one of the P parallelly connected registers;
P serial output ports respectively provided at serial terminals of the second registers; and
control means for causing addresses corresponding to the ports to be given to the other of the rows or columns selectively, for causing parallel loading into the parallelly connected registers or the second registers and for causing a shift operation of the parallelly connected registers.

It is to be understood that the invention is not limited to those specific embodiments described hereinabove, and that various changes and modifications may be effected therein without departing from the scope of the invention. For example, although the read-out/write-in multiports are shown connected to the column connecting lines of the memory, the memory could also be arranged such that the multiports are connected to the row connecting lines.

## Claims

1. A multiport memory comprising:
a first register (R1) having inputs connected to respective connecting lines of either the rows or columns of a semiconductor memory (1);
a second register (SR1) having inputs connected to respective outputs of said first register and permitting a serial shift;
a port provided at a serial terminal (S01) of said second register (SR1); and
control means (4) for controlling addressing of the semiconductor memory (1) and for controlling operation of the first and second registers (R1, SR1);
characterised in that:
the multiport memory comprises a plural number P of said first registers (R1, R2, R3), the inputs of a first one (R1) of the P first registers being connected to the respective connecting lines of either the rows or columns of the semiconductor memory (1) and the inputs of the or each subsequent one (e.g. R2) of the P first registers being connected to respective outputs of the preceding one (e.g. R1) of the P first registers;
the multiport memory also comprises a plural number P of said second registers (SR1, SR2, SR3), the inputs of each of the P second registers (SR1, SR2, SR3) being connected to the respective outputs of a respective one of the P first registers (R1, R2, R3);
each of the P second registers (SR1, SR2, SR3) permits a serial shift, and a respective said port is provided at a serial terminal (SO1, SO2, SO3) of each of the P second registers (SR1, SR2, SR3); and
the control means (4) is operative to cause an address to be supplied to either the columns or rows of the semiconductor memory, to cause a parallel load into the first of the P first registers (R1, R2, R3), and to cause a shift operation to sequentially cause a parallel load into the rest of the P first registers (R1, R2, R3) or to cause a load into the second registers (SR1, SR2, SR3).

2. A multiport memory according to claim 1, wherein said address is a read-out address.

3. A multiport memory according to claim 2, comprising:
a plurality of shift registers (SR1W, SR2W, SR3W) to be supplied with write-in data; and
a plurality of registers (R1W, R2W, R3W) each having inputs connected to outputs of a respective one of said shift registers (SR1W, SR2W, SR3W), outputs of a final one (R3W) of the plurality of registers (R1W, R2W, R3W) being connected to connecting lines of either the rows or columns of the semiconductor memory (1) and outputs of the or each preceding one (e.g. R2W) of the plurality of registers (R1W, R2W, R3W) being connected to inputs of the subsequent one (e.g. R3W) of the plurality of registers (R1W, R2W, R3W).

4. A multiport memory according to any one of the preceding claims, having a random access port.

## Patentansprüche

1. Multiportspeicher, der aufweist:
ein Erst-Register (R1), dessen Eingänge mit entsprechenden Verbindungsleitungen entweder der Reihen oder Spalten eines Halbleiterspeichers (1) verbunden sind;
ein Zweit-Register (SR1), dessen Eingänge mit entsprechenden Ausgängen des Erst-Registers verbunden sind und das eine serielle Verschiebung gestattet;
einen Port, der an einem seriellen Anschluß (SO1) des Zweit-Registers (SR1) vorgesehen ist; und
eine Steuereinrichtung (4), um das Adressieren des Halbleiterspeichers (1) und den Betrieb des Erst- und Zweit-Registers (R1, SR1) zu steuern;
**dadurch gekennzeichnet, daß**
der Multiportspeicher eine größere Anzahl P von Erst-Registern (R1, R2, R3) besitzt, wobei die Eingänge eines ersten (R1) der P Erst-Register mit den entsprechenden Verbindungsleitungen entweder der Reihen oder Spalten des Halbleiterspeichers (1) verbunden sind und die Eingänge des oder jedes folgenden (beispielsweise R2) der P Erst-Register mit entsprechenden Ausgängen des vorhergehenden (beispielsweise R1) der P Erst-Register verbunden sind;
der Multiportspeicher außerdem eine größere Anzahl P von Zweit-Registern (SR1, SR2, SR3) aufweist, wobei die Eingänge eines jeden der P Zweit-Register (SR1, SR2, SR3) mit den entsprechenden Ausgängen eines entsprechenden der P Erst-Register (R1, R2, R3) verbunden sind;
jedes der P Zweit-Register (SR1, SR2, SR3) eine serielle Verschiebung erlaubt, und ein entsprechender Port an einem seriellen Anschluß (SO1, SO2, SO3) eines jeden der P Zweit-Register (SR1, SR2, SR3) vorgesehen ist; und
die Steuereinrichtung (4) bewirkt, daß eine Adresse entweder an die Spalten oder Reihen des Halbleiterspeichers geliefert wird, um eine parallele Ladung in das erste der P Erst-Register (R1, R2, R3) zu bewirken, und um einen Verschiebebetrieb zur sequentiellen Bewirkung einer parallelen Ladung in den Rest der P Erst-Register (R1, R2, R3) oder um eine Ladung in die Zweit-Register (SR1, SR2, SR3) zu bewirken.

2. Multiportspeicher nach Anspruch 1, wobei die Adresse eine Leseadresse ist.

3. Multiportspeicher nach Anspruch 2, der aufweist:
mehrere Schieberegister (SR1W, SR2W, SR3W), die mit Schreibdaten beliefert werden; und
mehrere Register (R1W, R2W, R3W), die jeweils Eingänge haben, die mit Ausgängen eines entsprechenden der Schieberegister (SR1W, SR2W, SR3W) verbunden sind, wobei Ausgänge eines Schlußregisters (R3W) von mehreren Registern (R1W, R2W, R3W) mit Verbindungsleitungen entweder der Reihen oder Spalten des Halbleiterspeichers (1) verbunden sind und Ausgänge des oder jedes vorhergehenden (zum Beispiel R2W) der mehreren Register (R1W, R2W, R3W) mit Eingängen des nachfolgenden (z.B. R3W) der mehreren Register (R1W, R2W, R3W) verbunden sind.

4. Multiportspeicher nach einem der vorhergehenden Ansprüche, der einen Port mit wahlfreiem Zugriff hat.

## Revendications

1. Mémoire multiporte d'accès comprenant :
un premier registre (R1) ayant des entrées connectées à des fils de connexion respectifs soit des lignes soit des colonnes d'une mémoire à semiconducteurs (1) ;
un second registre (SR1) ayant des entrées connectées à des sorties respectives dudit premier registre et permettant un décalage en série ;
une porte d'accès prévue à une borne-série (SO1) dudit second registre (SR1) ; et,
un moyen de commande (4) pour commander l'adressage de la mémoire à semiconducteurs (1) et pour commander le fonctionnement des premier et second registres (R1, SR1) ;
caractérisée en ce que :
la mémoire multiporte d'accès comprend un nombre multiple P desdits premiers registres (R1, R2, R3), les entrées d'un premier (R1) des P premiers registres étant connectées aux fils de connexion respectifs soit des lignes soit des colonnes de la mémoire à semiconducteurs (1) et les entrées du ou de chaque registre suivant (par exemple R2) des P premiers registres étant connectées aux sorties respectives du précédent (par exemple R1) des P premiers registres ;
la mémoire multiporte d'accès comprend aussi un nombre multiple P desdits seconds registres (SR1, SR2, SR3), les entrées de chacun des P seconds registres (SR1, SR2, SR3) étant connectées aux sorties respectives de l'un correspondant des P premiers registres (R1, R2, R2) ;
chacun des P seconds registres (SR1, SR2, SR3) permet un décalage en série, et une dite porte d'accès respective est prévue à une borne-série (S01, S02, S03) de chacun des P seconds registres (SR1, SR2, SR3) ; et,
le moyen de commande (4) est actif pour qu'une adresse soit fournie soit aux colonnes soit aux lignes de la mémoire à semiconducteurs, pour produire un chargement en parallèle dans le premier des P premiers registres (R1, R2, R3), et pour faire en sorte qu'une opération de décalage produise séquentiellement un chargement en parallèle dans le reste des P premiers registres (R1, R2, R3) ou produise un chargement dans les seconds registres (SR1, SR2, SR3).

2. Mémoire multiporte d'accès selon la revendication 1, dans laquelle ladite adresse est une adresse de lecture.

3. Mémoire multiporte d'accès selon la revendication 2, comprenant :
une pluralité de registres à décalage (SR1W, SR2W, SR3W) auxquels sont fournies des données d'écriture ; et,
une pluralité de registres (R1W, R2W, R3W) ayant chacun des entrées connectées à des sorties de l'un respectif desdits registres à décalage (SR1W, SR2W, SR3W), des sorties d'un dernier (R3W) de la pluralité des registres (R1W, R2W, R3W) étant connectées à des fils de connexion soit des lignes soit des colonnes de la mémoire à semiconducteurs (1) et des sorties du ou de chaque registre précédent (par exemple R2W) de la pluralité des registres (R1W, R2W, R3W) étant connectées à des entrées du suivant (par exemple R3W) de la pluralité des registres (R1W, R2W, R3W).

4. Mémoire multiporte d'accès selon l'une quelconque des revendications précédentes, comportant une porte d'accès sélectif.
